# EUROPEAN PATENT APPLICATION

(11) **EP 3 832 330 A1**
(43) Date of publication of application: **09.06.2021**
(21) Application number: 19844719.5
(22) Date of filing: 31.07.2019
(51) Int. Cl.: G01R 31/392, H01M 10/42, H01M 10/48, H02J 7/00

(54) **ESTIMATION SYSTEM, ESTIMATION DEVICE, ESTIMATION METHOD, AND STORAGE MEDIUM**

(30) Priority: 31.07.2018 JP 2018143635
(71) Applicant: HONDA MOTOR CO., LTD., Minato-ku Tokyo 107-8556 (JP)
(72) Inventor: KAWAMURA Masayuki, Wako-shi, Saitama 351-0193 (JP); ENDO Hirotaka, Wako-shi, Saitama 351-0193 (JP)
(74) Representative: Feller, Frank
(86) International application number: PCT/JP2019/030035
(87) International publication number: WO 2020/027203

(57) **Abstract**

An estimation system includes a battery removably mounted on an electric power device using electric power, a charging device, and an estimation device. The charging device includes a charger configured to charge the battery, an acquirer configured to acquire first information about deterioration of the battery from the battery, and a transmitter configured to transmit the first information acquired by the acquirer. The estimation device includes a receiver configured to receive the first information transmitted by the transmitter and an estimator configured to estimate performance of the battery when the first information received by the receiver is input to a model, the model having been learned to output second information about the performance of the battery at a certain point in time when the first information of the battery is input at the point in time.

## Description

### TECHNICAL FIELD

The present invention relates to an estimation system, an estimation device, an estimation method, a program, and a storage medium.

Priority is claimed on Japanese Patent Application No. 2018-143635, filed July 31, 2018, the content of which is incorporated herein by reference.

### BACKGROUND ART

A sharing service in which a battery, which is a drive source of an electric vehicle, is removable and shared by a plurality of users is known. In this service, a charging station for storing and charging one or more removable batteries is installed and a mechanism for requesting a user who uses the charging station to pay a fee is constructed. Considering an operational aspect of the sharing service, removable batteries having different usage environments or usage state histories are mixed in one charging station. Also, the batteries used in the sharing service may deteriorate according to usage conditions and environmental conditions.

Conventionally, it is general to set a framework of a deterioration estimation method from physical characteristics of a battery, acquire deterioration parameters from durability test results of the battery, and construct battery deterioration prediction technology.

For example, a method of estimating a capacity of a lithium ion battery is described in Patent Document 1. In the technology described in Patent Document 1, a plurality of lithium ion batteries having the same structure and specifications as the lithium ion battery whose capacity is to be estimated and having capacities different due to a cause of repeated use or the like are provided. In the technology described in Patent Document 1, using the above, a lithium ion battery is charged in a constant current/constant voltage scheme and a charging current value at a point in time when the charging condition has been switched from a constant current to a constant voltage is measured. In the technology described in Patent Document 1, correlations between capacities of batteries having different capacity values and a charging current value are obtained in advance from a result of the measurement. In the technology described in Patent Document 1, when the lithium ion battery whose capacity is to be estimated is charged in the constant current/constant voltage scheme, a charging current value at a point in time when a preset time period has elapsed from a point in time when the charging condition has been switched from the constant current to the constant voltage is obtained. In the technology described in Patent Document 1, the capacity of the lithium ion battery serving as a target of capacity estimation is estimated from correlations between capacities of batteries having different capacity values obtained in advance and the charging current value using the charging current.

In Patent Document 2, technology for ascertaining a value of internal resistance of a secondary battery which has deteriorated after the elapse of a predetermined time period with high accuracy by calculating an amount of change in the internal resistance after the elapse of the predetermined time period in consideration of information of the temperature to which the battery is exposed with respect to an initial value of the internal resistance in relation to the prediction of deterioration of the internal resistance is described. In the technology described in Patent Document 1, for the temperature information, temperature progress information including a battery temperature and time information in which the battery temperature is recorded is acquired over time. In the technology described in Patent Document 1, the temperature progress information is acquired at least at a predetermined frequency when the battery is used, for example, every 1 minute to 12 hours.

In Patent Document 3, as another example of a movable object in which a battery can be removably mounted on a main body of the movable object, a portable power charging/supplying device including a battery and a power charging/supplying unit in which a storage chamber for storing the battery is formed is described.

### PRIOR ART DOCUMENTS

### PATENT DOCUMENTS

[Patent Document 1]
   Japanese Unexamined Patent Application, First Publication No. 2001-257008
[Patent Document 2]
   Japanese Unexamined Patent Application, First Publication No. 2017-009540
[Patent Document 3]
   Japanese Unexamined Patent Application, First Publication No. 2019-068552

### SUMMARY OF INVENTION

### PROBLEMS TO BE SOLVED BY THE INVENTION

However, in the conventional technology, deterioration cannot be predicted without knowledge of a battery. Also, in the conventional technology, a framework of a change in deterioration made from physical properties may not actually be suitable.

Aspects of the present invention provide an estimation system, an estimation device, an estimation method, a program, and a storage medium capable of estimating a change in deterioration of a battery without having specialized knowledge about deterioration of the battery.

### SOLUTION TO PROBLEM

(1) According to an aspect of the present invention, there is provided an estimation system including: a battery removably mounted on an electric power device using electric power; a charging device; and an estimation device, wherein the charging device includes a charger configured to charge the battery; an acquirer configured to acquire first information about deterioration of the battery from the battery; and a transmitter configured to transmit the first information acquired by the acquirer, and wherein the estimation device includes a receiver configured to receive the first information transmitted by the transmitter; and an estimator configured to estimate performance of the battery when the first information received by the receiver is input to a model, the model having been learned to output second information about the performance of the battery at a certain point in time when the first information of the battery is input at the point in time.
(2) In the estimation system, the estimation device may further include a learner configured to learn the model based on teacher data in which the second information of the battery at the point in time is associated with the first information of the battery at the point in time.
(3) In the estimation system, the first information may include at least one of the number of days elapsed after the battery was produced, the initial capacity of the battery, the initial resistance value of the battery, a histogram of the temperature of the battery, and a histogram of the remaining capacity of the battery.
(4) In the estimation system, the second information may include one or both of a capacity of the battery at the time of measurement and a resistance value of the battery at the time of measurement.
(5) In the estimation system, the first information may include at least one of the number of days elapsed after the battery was produced, the initial capacity of the battery, the initial resistance value of the battery, the standard deviation and the average value in the temperature of the battery, and the standard deviation and the average value in the remaining capacity of the battery.
(6) In the estimation system, the acquirer of the charging device may acquire the first information and the second information when the battery has been mounted on the charging device, and the transmitter of the charging device may transmit the first information and the second information acquired by the acquirer to the estimation device.
(7) In the estimation system, the acquirer of the charging device may acquire the first information and the second information for a period from the time when the battery is mounted on the charging device to the time when the battery is removed from the charging device, and the transmitter of the charging device may transmit the first information and the second information acquired by the acquirer to the estimation device.
(8) In the estimation system, the second information may include at least one of measured values of a capacity and a resistance value obtained by measuring the performance of the battery and time-series data of each of the voltage, the electric current, and the temperature when the battery is charged.
(9) According to another aspect of the present invention, there is provided an estimation system including: a battery removably mounted on an electric power device using electric power; and an estimation device, wherein the battery includes an acquirer configured to acquire first information about deterioration of the battery; and a transmitter configured to transmit the first information acquired by the acquirer, and wherein the estimation device includes a receiver configured to receive the first information transmitted by the transmitter; and an estimator configured to estimate performance of the battery when the first information received by the receiver is input to a model, the model having been learned to output second information about the performance of the battery at a certain point in time when the first information of the battery is input at the point in time.
(10) According to further another aspect of the present invention, there is provided an estimation device including: a receiver configured to receive first information about deterioration of a battery transmitted by a charging device configured to charge the battery removably mounted on an electric power device using electric power; and an estimator configured to estimate performance of the battery when the first information received by the receiver is input to a model, the model having been learned to output second information about the performance of the battery at a certain point in time when the first information of the battery is input at the point in time.
(11) According to still another aspect of the present invention, there is provided an estimation method including a step of: estimating, by a computer including a receiver configured to receive first information about deterioration of a battery transmitted by a charging device configured to charge the battery removably mounted on an electric power device using electric power, performance of the battery when the first information received by the receiver is input to a model, the model having been learned to output second information about the performance of the battery at a certain point in time when the first information of the battery is input at the point in time.
(12) According to still another aspect of the present invention, there is provided a program for causing a computer, which includes a receiver configured to receive first information about deterioration of a battery transmitted by a charging device configured to charge the battery removably mounted on an electric power device using electric power, to execute a step of: estimating performance of the battery when the first information received by the receiver is input to a model, the model having been learned to output second information about the performance of the battery at a certain point in time when the first information of the battery is input at the point in time.
(13) According to still another aspect of the present invention, there is provided a computer-readable storage medium storing the program.

### ADVANTAGEOUS EFFECTS OF INVENTION

According to the above-described (1) and (8) to (13), it is possible to estimate a change in deterioration of the battery without having specialized knowledge about the deterioration of the battery. Also, according to the above-described (1) or (7), it is expected that the accuracy of estimation will be further improved when more batteries are released onto the market. Further, according to the above-described (1) or (8) to (13), because it is possible to estimate the capacity and the resistance value of the battery without acquiring much time-series data at certain short time intervals, the cost of collecting data in the market can be reduced.

According to the above-described (3) or (4), because machine learning is performed using information for determining deterioration of the battery and information about battery performance, it is possible to generate a model for enabling a change in the deterioration of the battery to be estimated accurately.

According to the above-described (5) or (6), when the battery is returned or for a period from the time the battery is returned to the time when the battery is rented, the battery performance can be measured by the charging device and the battery information can be obtained, so that the cost of collecting data in the market can be reduced.

According to the above-described (7), because the second information used as a teacher label of the teacher data includes time-series data of various types of parameters representing the battery performance, it is not necessary to actually measure the battery performance for the battery and it is possible to improve the accuracy of prediction as the number of data samples increases.

### BRIEF DESCRIPTION OF THE DRAWINGS

Fig. 1 is a diagram showing the overall configuration of a battery deterioration estimation system according to an embodiment.
Fig. 2 is a diagram showing an example of a configuration of a removable battery according to the embodiment.
Fig. 3 is a diagram showing an example of a configuration of a charging station according to the embodiment.
Fig. 4 is a diagram showing an example of a configuration of a management server according to the embodiment.
Fig. 5 is a flowchart of a procedure of creating a battery deterioration prediction model according to the embodiment.
Fig. 6 is a diagram showing an example in which a battery deterioration prediction model is generated according to the embodiment.
Fig. 7 is a flowchart of an example of a process in which battery performance is estimated using the battery deterioration prediction model according to the embodiment.
Fig. 8 is a diagram showing an example in which battery performance is estimated using the battery deterioration prediction model according to the embodiment.
Fig. 9 is a diagram showing an example of histogram data of the temperature of the removable battery according to the embodiment.
Fig. 10 is a diagram showing an example of histogram data of a state of charge (SOC) of the removable battery according to the embodiment.
Fig. 11 is a diagram showing an example of data for use in learning according to the embodiment.
Fig. 12 is a flowchart of a procedure of creating a battery deterioration prediction model according to a first modified example of the embodiment.
Fig. 13 is a diagram showing the overall configuration of a battery deterioration estimation system according to a second modified example of the embodiment.

### DESCRIPTION OF EMBODIMENTS

Hereinafter, embodiments of the present invention will be described with reference to the drawings. Also, in the drawings used in the following description, the scale of each member is appropriately changed to make each member recognizable.

### [Overall configuration]

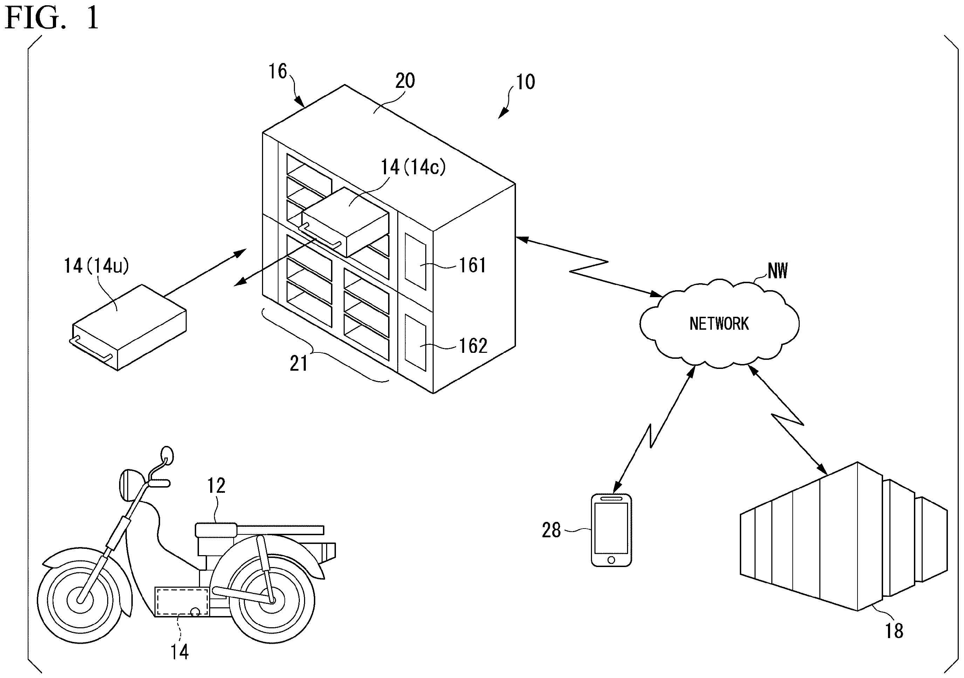

Fig. 1 is a diagram showing the overall configuration of a battery deterioration estimation system 10 according to the present embodiment. As shown in Fig. 1, the battery deterioration estimation system 10 includes a saddle-riding type motorcycle 12, a removable battery 14, a charging station 16, a management server 18, and a portable terminal 28. The motorcycle 12 is an example of an "electric power device," the charging station 16 is an example of a "charging device," and the management server 18 is an example of an "estimation device."

The "electric power device" is not limited to the motorcycle 12 and may be, for example, a vehicle (a one-wheel vehicle, a three-wheel vehicle, a four-wheel vehicle, or the like) which can travel with electric power and on which a removable battery 14 can be removably mounted, or an assist-type bicycle. Instead of these vehicle-type movable objects, the "electric power device" may be a portable power charging/supplying device carried by a person or a vehicle described in Japanese Unexamined Patent Application, First Publication No. 2019-068552. Also, the "electric power device" may be a movable robot, an autonomous traveling device, an electric bicycle, an autonomous traveling vehicle, another electric vehicle, a drone flying object, or another electric movable device (electric mobility). Hereinafter, an example in which the "electric power device" is the motorcycle 12 will be described.

The battery deterioration estimation system 10 is a system capable of providing a sharing service in which a removable battery 14, which is a drive source of the motorcycle 12, is shared by a plurality of users.

The removable battery 14 is a cassette-type power storage device that is removably mounted on the motorcycle 12 that can travel with at least electric power. The removable battery 14 stores battery information about deterioration of the battery. Hereinafter, for convenience of description, the removable battery 14 required to be charged may be distinguished as a "used battery 14u" and the removable battery 14 that has been completely charged may be distinguished as a "charged battery 14c." At least one removable battery 14 is mounted on one motorcycle 12. A configuration of the removable battery 14 will be described below. For example, the battery information includes various types of parameters for enabling deterioration of the removable battery 14 to be diagnosed such as the number of days of use of the removable battery 14, initial performance (the capacity and the resistance value), a histogram of the temperature, and a histogram of the state of charge (SOC). The battery information may further include identification information (also referred to as a battery ID) of the removable battery 14. In the present embodiment, it is assumed that there is only one type of removable battery 14 used in the battery deterioration estimation system 10. The battery information is an example of "first information."

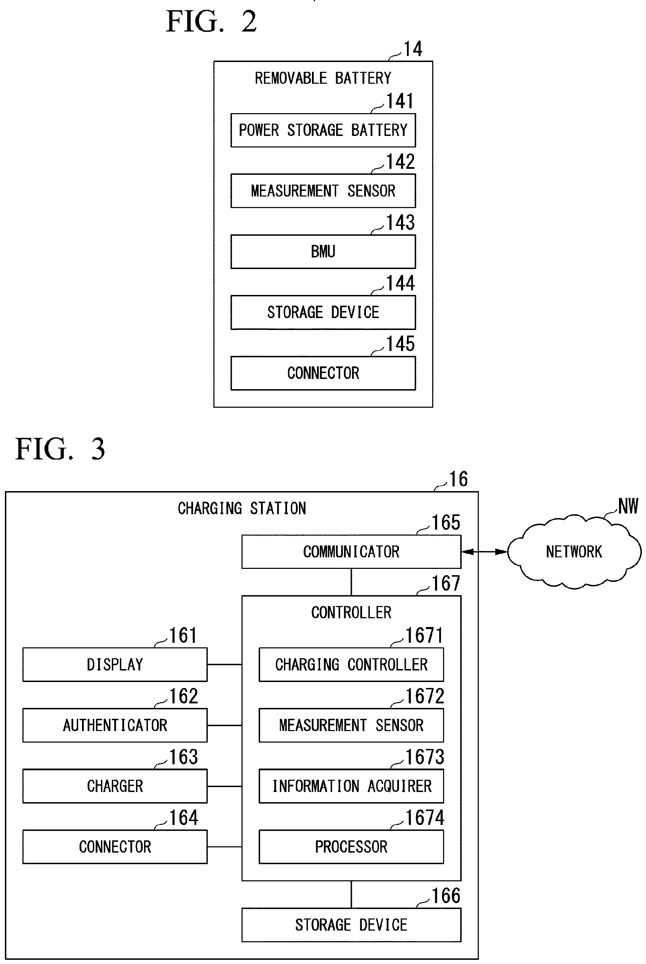

The charging station 16 is a facility for storing and charging one or more removable batteries 14 and is installed at a plurality of places. A housing 20 of the charging station 16 includes a slot unit 21 having a plurality of slots (12 slots in the example of Fig. 1), a display 161 and an authenticator 162. The charging station 16 is connected to the management server 18 via the network NW so that communication with the management server 18 is enabled. The network NW is a wireless communication network or a wired communication network. A charger 163 (Fig. 3) capable of charging the removable battery 14 and a connector 164 (Fig. 3) are provided on the back side of the slot unit 21. The charging station 16 acquires battery information from the removable battery 14 inserted into the slot unit 21. The charging station 16 measures (estimates) battery performance (a capacity and a resistance value) of the removable battery 14 inserted into the slot unit 21, associates information about the measured (estimated) battery performance (hereinafter referred to as battery performance information) with the acquired battery information, and transmits the associated information to the management server 18. The charging station 16 transmits the number of used batteries 14u and the number of charged batteries 14c to the management server 18. The battery performance information is an example of "second information."

The management server 18 acquires the number of used batteries 14u and the number of charged batteries 14c transmitted by the charging station 16 and manages the removable battery 14 stored in the charging station 16 based on the acquired information. The management server 18 performs a reservation process for renting the removable battery 14 based on, for example, a result of an operation of a user performed on the portable terminal 28. The management server 18 transmits a reservation result to the portable terminal 28. The management server 18 performs a billing process in accordance with a situation in which the user uses the removable battery 14. A billing method may be an annual contract, a monthly contract, a contract based on a use count, or a one-time contract. The management server 18 is connected to the charging station 16 and the portable terminal 28 via the network NW so that communication is enabled.

The management server 18 generates a model for predicting deterioration of the removable battery 14 (a battery) (hereinafter referred to as a battery deterioration prediction model) through machine learning using the battery information associated with the battery performance information acquired from the plurality of removable batteries 14 as the teacher data. When the battery deterioration prediction model is sufficiently learned, the management server 18 predicts the battery capacity and the battery resistance at any timing using the battery deterioration prediction model. The battery deterioration prediction model is a model for all the removable batteries 14 used in the battery deterioration estimation system 10. A method of generating the battery deterioration prediction model and a method of predicting the battery capacity and the battery resistance will be described below.

The portable terminal 28 is a terminal carried by the user, for example, such as a smartphone, a tablet terminal, or a notebook computer. The user operates the portable terminal 28 to select and reserve one of the charging stations 16 from which the removable battery 14 can be rented. The portable terminal 28 transmits an operation result to the management server 18.

### [Configuration of removable battery 14]

Next, an example of a configuration of the removable battery 14 will be described.

Fig. 2 is a diagram showing the example of the configuration of the removable battery 14 according to the present embodiment. As shown in Fig. 2, the removable battery 14 includes a power storage battery 141, a measurement sensor 142, a battery management unit (BMU) 143, a storage device 144, and a connector 145.

The power storage battery 141 is, for example, any one of a secondary battery, a lead storage battery, a capacitor, a lithium ion battery, and the like.

The measurement sensor 142 includes various types of sensors that measure electric current and temperature. The measurement sensor 142 outputs a measured value to the BMU 143. A temperature sensor measures the temperature of the power storage battery 141. An electric current sensor measures the value of the electric current which flows through the power storage battery 141.

The BMU 143 controls charging and power supply for the power storage battery 141. For example, the BMU 143 causes the storage device 144 to store the measured value output by the measurement sensor 142 at each predetermined timing. For example, the BMU 143 causes SOC information of the removable battery 14 to be stored at each predetermined timing. The predetermined timing is, for example, every minute. When the removable battery 14 is inserted into the slot unit 21 of the charging station 16, the BMU 143 outputs information stored in the storage device 144 to the charging station 16. The information stored in the storage device 144 after the measurement performed by the BMU 143 is not limited to the temperature and the SOC of the battery and it is only necessary for the information to be an element for estimating deterioration of the removable battery 14.

The storage device 144 stores identification information of the removable battery 14, information about the initial performance of the removable battery 14, (temperature information including) measured values of the measurement sensor 142 from the time of renting to the time of returning, and SOC information of the removable battery 14 from the time of renting to the time of returning, and the like. The initial performance information is about the initial capacity of the power storage battery 141 and the initial resistance value of the power storage battery 141. The storage device 144 stores a program that causes the BMU 143 to execute a process.

The connector 145 is a connector associated with the slot unit 21 of the charging station 16 and has a communication function.

### [Configuration of charging station 16]

Next, an example of a configuration of the charging station 16 will be described.

Fig. 3 is a diagram showing the example of the configuration of the charging station 16 according to the present embodiment. As shown in Fig. 3, the charging station 16 includes a display 161, an authenticator 162, a charger 163, a connector 164, a communicator 165, a storage device 166, and a controller 167.

The controller 167 includes a charging controller 1671, a measurement sensor 1672, an information acquirer 1673, and a processor 1674.

The display 161 is any one of a liquid crystal display device, an organic electro luminescence (EL) display device, an electronic ink display device, and the like. The display 161 displays information output by the controller 167. For example, the displayed information is about the remaining capacity of the removable battery 14, a usage fee of the removable battery 14, and the like.

The authenticator 162 is equipment that reads recorded information of a near field communication (NFC) card (not shown) carried by a user using, for example, NFC. Thereby, the charging station 16 authenticates a user who has the authority to use the sharing service using a user ID included in the recorded information. The authenticator 162 outputs the acquired user ID to the controller 167.

The charger 163 is equipment that charges the removable battery 14 in accordance with control of the controller 167 under a state in which the connector 145 of the removable battery 14 and the connector 164 of the charging station 16 are connected. A power supply (not shown) for supplying electric power to the removable battery 14 is connected to the charger 163. The charger 163 is an example of a "charger."

The connector 164 is a connector associated with the removable battery 14 and supplies electric power and transmits and receives information. The connector 164 acquires battery information from the removable battery 14 and outputs the acquired battery information to the information acquirer 1673.

The communicator 165 transmits the battery performance information and the battery information to which the identification information of the charging station 16 output by the controller 167 is added to the management server 18 via the network NW The communicator 165 receives reservation information of the removable battery 14 transmitted by the management server 18 and outputs the received reservation information of the removable battery 14 to the controller 167. The communicator 165 transmits the number of rentable removable batteries 14 given by the charging station 16 and output by the controller 167 and the like to the management server 18. The communicator 165 transmits the user ID to which the identification information of the charging station 16 is added output by the controller 167 to the management server 18.

The storage device 166 stores the identification information of the charging station 16, the battery information of each of the removable batteries 14 inserted into the slot unit 21, and the like. The storage device 166 stores a program that causes the controller 167 to execute the process.

The controller 167 acquires the battery performance information and the battery information output by the connector 164 and causes the storage device 166 to store the acquired battery performance information and the acquired battery information. The controller 167 measures or estimates the battery performance (the capacity and the resistance value) of the removable battery 14 that has been returned and inserted into the slot unit 21 of the charging station 16. The controller 167 adds the identification information of the charging station 16 to the battery information and the battery performance information stored in the storage device 166 and outputs the battery information and the battery performance information to the communicator 165. The controller 167 functions as the charging controller 1671, the information acquirer 1673, and the processor 1674 by reading and executing the program stored in the storage device 166. The controller 167 detects the number of rentable removable batteries 14 based on the information stored in the storage device 166, adds the identification information of the charging station 16 to the detected number of rentable removable batteries 14, and outputs the detected number of rentable removable batteries 14 to the communicator 165.

The controller 167 permits the user to rent the removable battery 14 when the user has been successfully authenticated by the authenticator 162. The controller 167 acquires the user ID output by the authenticator 162, adds the identification information of the charging station 16 to the acquired user ID, and outputs the user ID to the communicator 165.

The charging controller 1671 controls the charger 163 based on the measured value of the measurement sensor 1672 and controls a process of charging the removable battery 14 inserted into the slot unit 21.

The measurement sensor 1672 is, for example, an electric current sensor or a voltage sensor. The measurement sensor 1672 measures an electric current value and a voltage value when an electric current flows through the removable battery 14 and outputs measured values thereof to the charging controller 1671.

The information acquirer 1673 acquires battery information from the removable battery 14 connected to the connector 164 and causes the storage device 166 to store the acquired battery information.

The processor 1674 estimates the battery performance (the capacity and the resistance value) of the removable battery 14 based on the measured value of the measurement sensor 1672. The processor 1674 generates histogram data of the temperature of the battery based on the temperature information included in the battery information acquired by the information acquirer 1673. The processor 1674 generates histogram data of an SOC of the battery based on the temperature information included in the battery information acquired by the information acquirer 1673. In the case of a normal distribution, the histogram data of the temperature of the battery can be replaced with an average value and the standard deviation therein. In the case of a normal distribution, the histogram data of the SOC of the battery can be replaced with the average value and the standard deviation therein.

### [Configuration of management server 18]

Next, an example of a configuration of the management server 18 will be described.

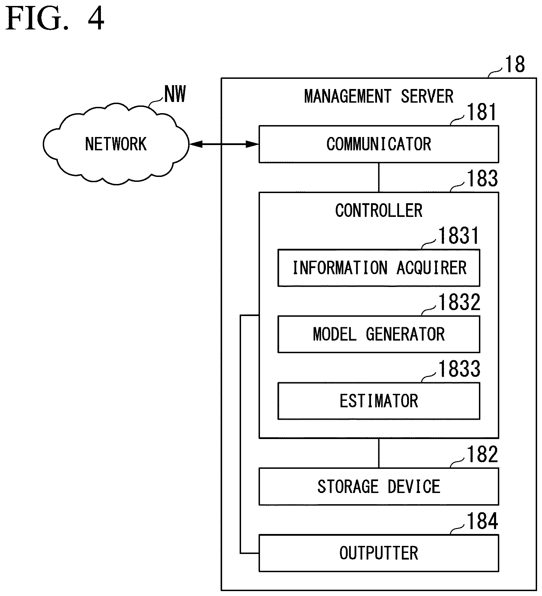

Fig. 4 is a diagram showing the example of the configuration of the management server 18 according to the present embodiment. As shown in Fig. 4, the management server 18 includes a communicator 181, a storage device 182, a controller 183, and an outputter 184. The controller 183 includes an information acquirer 1831, a model generator 1832, and an estimator 1833. The model generator 1832 is an example of a "learner."

The communicator 181 receives the battery performance information and the battery information transmitted by the charging station 16 via the network NW and outputs the received battery performance information and the received battery information to the controller 183. The communicator 181 transmits the reservation information of the removable battery 14 output by the controller 183 to the portable terminal 28 via the network NW

The storage device 182 stores the battery deterioration prediction model generated by the model generator 1832. The storage device 182 stores a program that causes the controller 183 to execute the process.

The controller 183 acquires the battery performance information and the battery information output by the communicator 181 and generates a battery deterioration prediction model through machine learning using the acquired battery performance information and the acquired battery information. The controller 183 estimates the battery capacity and the battery resistance using the generated battery deterioration prediction model. The controller 183 outputs the estimated battery capacity and the estimated battery resistance to the outputter 184.

The information acquirer 1831 acquires the battery performance information and the battery information output by the communicator 181 and outputs the acquired battery performance information and the acquired battery information to the model generator 1832.

The model generator 1832 generates a battery deterioration prediction model through machine learning using the battery performance information and the battery information output by the information acquirer 1831 and causes the storage device 182 to store the generated battery deterioration prediction model. A method of generating the battery deterioration prediction model will be described below.

The estimator 1833 estimates the battery capacity and the battery resistance using the battery deterioration prediction model at any timing.

The outputter 184 is an image display device, a printing device, or the like. The outputter 184 displays or prints the battery capacity and the battery resistance output by the controller 183.

### [Procedure of generating battery deterioration prediction model]

Next, a procedure for generating a battery deterioration prediction model will be described.

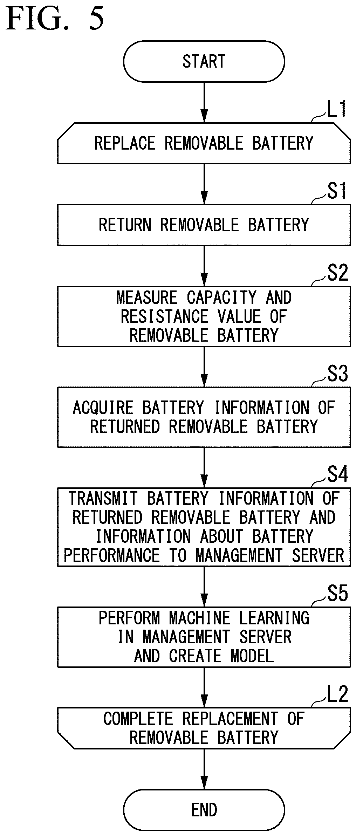

Fig. 5 is a flowchart of the procedure of generating the battery deterioration prediction model according to the present embodiment. The following process is performed, for example, when a user visits the charging station 16 and replaces the removable battery 14.

(Step L1) The replacement work of the removable battery 14 starts.

(Step S1) The controller 167 of the charging station 16 detects that the removable battery 14 has been returned to the slot unit 21. For example, the controller 167 recognizes that the removable battery 14 has been returned when the connector 164 can acquire information from the removable battery 14.

(Step S2) The measurement sensor 1672 measures a capacity and a resistance value of the removable battery 14 returned to the slot unit 21 and the processor 1674 acquires battery performance information including the capacity and the resistance value of the removable battery 14 measured by the measurement sensor 1672 when the removable battery 14 has been returned (when the removable battery 14 has been inserted into the slot unit 21) from the measurement sensor 1672.

(Step S3) The information acquirer 1673 acquires the battery information stored in the storage device 144 of the removable battery 14 via the connector 164. The acquired battery information includes at least a part or preferably all of information indicating a production date of the removable battery 14, initial performance (a capacity and a resistance value) of the removable battery 14, histogram data of the temperature of the removable battery 14, and histogram data of an SOC of the removable battery 14.

(Step S4) The controller 167 adds identification information of the charging station to the battery performance information including the capacity and the resistance value when the removable battery 14 is returned and the battery information stored in the storage device 144 of the removable battery 14 and transmits the battery performance information and the battery information to the management server 18.

(Step S5) The information acquirer 1831 of the management server 18 acquires the battery information and the battery performance information transmitted by the charging station 16 via the communicator 181.

Subsequently, the model generator 1832 of the management server 18 calculates the number of days elapsed after the removable battery 14 was produced based on the production date included in the acquired battery information and the present date.

Subsequently, the model generator 1832 of the management server 18 generates data in which the acquired battery information is associated with the acquired battery performance information serving as a teacher label as teacher data (training data) and generates a battery deterioration prediction model through machine learning using the generated teacher data. Thereby, the battery deterioration prediction model is learned to output the battery performance information of the removable battery 14 at the same time when the battery information of the removable battery 14 at a certain point in time is input.

Subsequently, the model generator 1832 causes the storage device 182 to store the generated battery deterioration prediction model.

(Step L2) The replacement work of the removable battery 14 is completed.

The controller 183 of the management server 18 acquires battery information and battery performance information including measured values such as a capacity and a resistance value every time the removable battery 14 is replaced and updates the battery deterioration prediction model through machine learning.

Although an example in which the battery performance is measured when the removable battery 14 is replaced and the battery information is acquired and transmitted to the management server 18 has been described in the example shown in Fig. 5, the present invention is not limited thereto. A timing when the battery performance is measured, a timing when the battery information is acquired, or a timing of transmission to the management server 18 may be a timing when the removable battery 14 is returned or after the return.

Next, machine learning of the battery deterioration prediction model will be described.

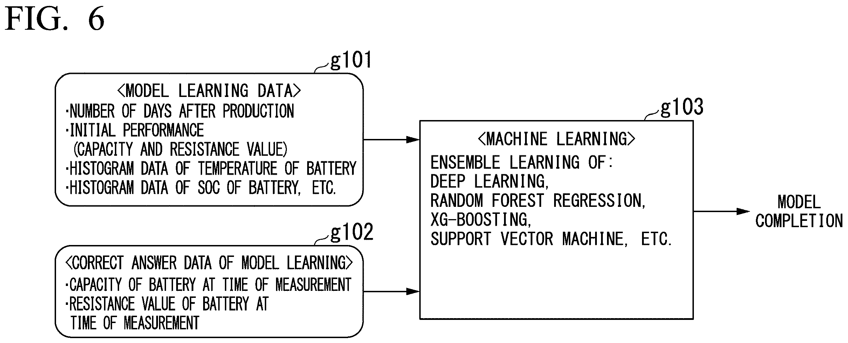

Fig. 6 is a diagram showing an example in which the battery deterioration prediction model is generated according to the present embodiment.

Reference sign g101 denotes an example of battery information (hereinafter also referred to as model learning data) with which the teacher label is associated. In the example denoted by reference sign g101, the model learning data includes the number of days elapsed after the removable battery 14 was produced, the initial performance (the capacity and the resistance value) of the removable battery 14, the histogram data of the temperature of the removable battery 14, the histogram data of the SOC of the removable battery 14, and the like.

Reference sign 102 denotes an example of battery performance information (hereinafter also referred to as correct answer data of model learning) serving as the teacher label. In the example denoted by reference sign g102, the correct answer data of the model learning represents a battery capacity at the time of measurement and a battery resistance value at the time of measurement.

Reference sign 103 denotes an example of a learning engine for machine learning. As denoted by reference sign g103, an engine of the machine learning includes, for example, deep learning, random forest regression (random forest), extreme gradient boosting (XG-boosting), a support vector machine, ensemble learning thereof, and the like. The ensemble learning is, for example, bagging, boosting, or the like.

As shown in Fig. 6, the model generator 1832 learns the battery deterioration prediction model according to a learning method such as deep learning using teacher data in which the correct answer data of the model learning is associated with the model learning data. Thereby, the battery deterioration prediction model is generated.

### [Battery performance estimation process using battery deterioration prediction model]

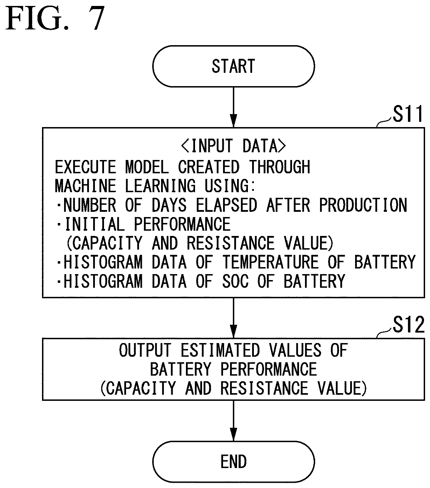

Next, an example of a process of estimating battery performance using the generated battery deterioration prediction model will be described. Fig. 7 is a flowchart of the example of the process of estimating the battery performance using the battery deterioration prediction model according to the present embodiment. The management server 18 performs the process of Fig. 7 at any timing.

(Step S11) The controller 183 of the management server 18 executes the battery deterioration prediction model stored in the storage device 182 using the input data. The input data includes information indicating the number of days elapsed after the removable battery 14 was produced, initial performance (a capacity and a resistance value) of the removable battery 14, histogram data of the temperature of the removable battery 14, and histogram data of an SOC of the removable battery 14. That is, the input data may be the battery information itself acquired by the management server 18 from the charging station 16. Alternatively, the input data may be data obtained by performing appropriate processing or the like on the battery information acquired from the charging station 16 by the management server 18.

(Step S12) The controller 183 estimates battery performance (a capacity and a resistance value) at present according to the processing of step S11. For example, the controller 183 inputs battery information as input data to the battery deterioration prediction model sufficiently learned using the teacher data and estimates the battery performance such as the capacity and the resistance value of the removable battery 14 at present based on battery performance information output by the battery deterioration prediction model to which the battery information is input.

Subsequently, the controller 183 outputs the estimated battery performance to the outputter 184. Subsequently, the outputter 184 displays, for example, the battery performance.

For example, the management server 18 may acquire the number of days after the production of the removable battery 14 and the initial performance (the capacity and the resistance value) among a plurality of information elements included in the input data from a production factory (not shown) of the removable battery 14 that manages the production date and the initial performance of the removable battery 14 in association with identification information of the removable battery 14. Alternatively, in relation to the number of days after the production of the removable battery 14 and the initial performance (the capacity and the resistance value), for example, the production factory of the removable battery 14 may cause the storage device 144 of the removable battery 14 to store the production date and the initial performance of the removable battery 14. In this case, the charging station 16 may read the production date and initial performance of the removable battery 14 stored in the storage device 144 of the removable battery 14 when the removable battery 14 is returned and transmit the read production date and the read initial performance of the removable battery 14 to the management server 18.

In relation to the temperature histogram data and the SOC histogram, for example, a program for causing the BMU 143 to create a histogram for a usage history from the production date to a present point in time may be implemented in the storage device 144 of the removable battery 14 at a production factory or the like. The charging station 16 may read the histogram data from the storage device 144 when the removable battery 14 has been inserted into the slot unit 21 and transmit the read histogram data to the management server 18. The controller 167 of the charging station 16 may create the histogram. In this case, the controller 167 may create the histogram when the removable battery 14 has been inserted into the slot unit 21. Alternatively, when the motorcycle 12 includes a communicator as described below, the communicator provided in the motorcycle 12 may transmit SOC data and temperature data to the management server 18 at predetermined time intervals. In this case, the management server 18 may create the histogram using the above-described time-series data received from the communicator provided in the motorcycle 12.

The estimator 1833 may further perform the estimation of the time when the currently used removable battery 14 will be replaced with a new one based on the estimated battery performance, the initial performance of the battery, the number of days elapsed from production, and the like.

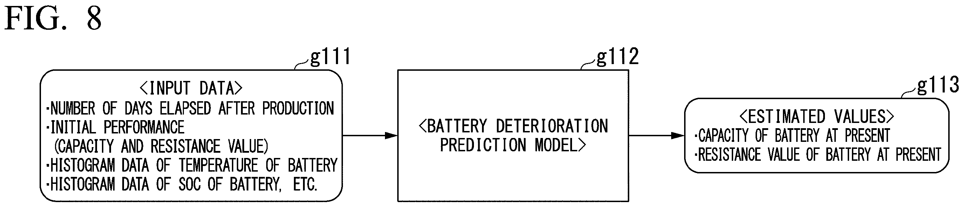

Next, the estimation of the battery performance using the battery deterioration prediction model will be described. Fig. 8 is a diagram showing an example in which the battery performance is estimated using the battery deterioration prediction model according to the present embodiment.

Reference sign gill denotes an example of input data. As denoted by reference sign gill, the input data includes information indicating the number of days elapsed after the removable battery 14 was produced, the initial performance (the capacity and the resistance value) of the removable battery 14, the histogram data of the temperature of the removable battery 14, the histogram data of the SOC of the removable battery 14, and the like.

Reference sign 112 denotes a battery deterioration prediction model generated through machine learning. Reference sign g113 denotes estimated values output by the battery deterioration prediction model. As denoted by reference sign g113, the estimated values are the current battery capacity and the current resistance value of the battery.

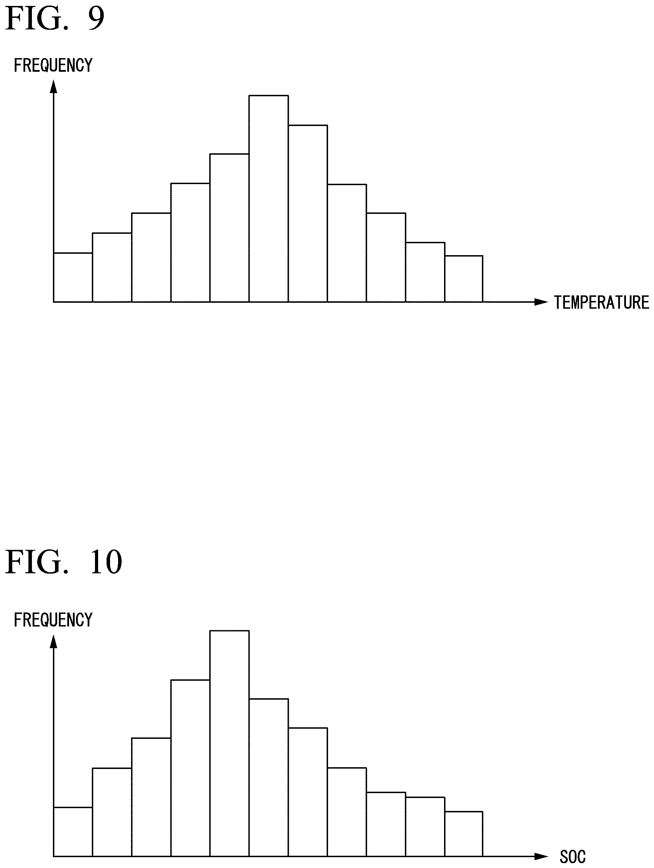

An example of the histogram data of the temperature of the removable battery 14 and an example of the histogram data of the SOC of the removable battery 14 will be described. Fig. 9 is a diagram showing an example of the histogram data of the temperature of the removable battery 14 according to the present embodiment. In Fig. 9, the horizontal axis represents the temperature [degrees] and the vertical axis represents a frequency.

Fig. 10 is a diagram showing an example of the histogram data of the SOC of the removable battery 14 according to the present embodiment. In Fig. 10, the horizontal axis represents an SOC [%] and the vertical axis represents a frequency.

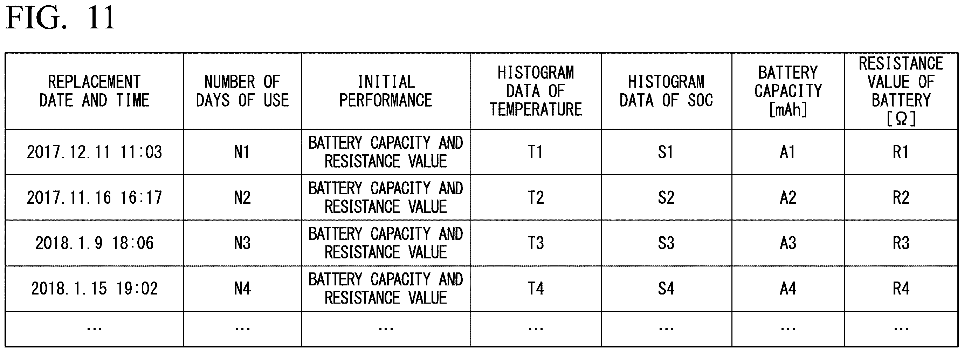

Next, an example of data used for learning will be described. Fig. 11 is a diagram showing an example of data used for learning according to the present embodiment. As shown in Fig. 11, the controller 183 of the management server 18 acquires battery information (the number of days of use and initial performance (a capacity and a resistance value), a temperature histogram, and an SOC histogram) and battery performance (a capacity and a resistance value) corresponding to actually measured values every time the removable battery 14 is replaced. For example, assuming that there are 1000 removable batteries 14 used in the battery deterioration estimation system 10, the controller 183 acquires the battery information and the actually measured values every time the removable battery 14 is replaced with respect to each of 1000 removable batteries 14(1) to 14(1000) (not shown). Thus, the controller 183 acquires data used for learning a plurality of times for one removable battery 14(1) for each replacement. A variation in how the removable battery 14 is used is included in temperature histogram information and SOC histogram information in the battery information, and the battery performance (the capacity and the resistance value) corresponding to the actually measured values.

The controller 183 does not use the identification information of the removable battery 14 and the identification information of the charging station 16 for the learning data. However, when there are a plurality of types of the removable battery 14 used in the battery deterioration estimation system 10, the controller 183 associates the type of battery with the identification information of the removable battery 14 used in the battery deterioration estimation system 10 in advance and causes the storage device 182 to store an association result. In this case, it is assumed that a mechanism of deterioration differs according to each type of removable battery 14. Thus, the controller 183 may identify the type of removable battery 14 based on the identification information of the removable battery 14 included in the acquired battery information and the information stored in the storage device 182 and generate a battery deterioration prediction model for each type of removable battery 14.

As described above, in the present embodiment, the battery deterioration prediction model is learned using the battery information and the battery performance information. In the present embodiment, the capacity and the resistance value of the removable battery 14 are estimated using the learned battery deterioration prediction model.

Thereby, according to the present embodiment, it is possible to predict a change in deterioration of the removable battery 14 without any specialized knowledge about the deterioration of the battery. Also, according to the present embodiment, it is expected that the larger number of removable batteries 14 in the market will be associated with the higher prediction accuracy.

Further, according to the present embodiment, it is possible to predict the capacity and the resistance value of the removable battery 14 without acquiring much time-series data at certain short time intervals, so that the cost of collecting data in the market can be reduced.

### [First modified example]

Although an example in which the battery performance such as the resistance value of the removable battery 14 on the charging station 16 side is obtained through measurement has been described in the example described with reference to Fig. 5, the present invention is not limited thereto. The battery performance may be estimated on the management server 18 side.

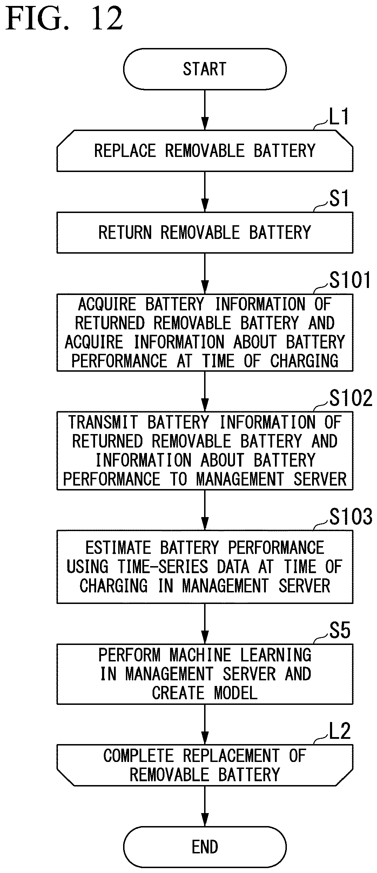

Fig. 12 is a flowchart of a procedure of creating a battery deterioration prediction model according to the first modified example of the present embodiment. Processing similar to that in Fig. 5 is denoted by the same reference signs and a description thereof will be omitted.

(Step L1) The replacement work of the removable battery 14 starts.

(Step S1) The controller 167 of the charging station 16 performs the processing of step S1 and the process proceeds to the processing of step S101 after the processing of step S1.

(Step S101) The information acquirer 1673 acquires the battery information stored in the storage device 144 of the removable battery 14 via the connector 164. The acquired battery information includes information indicating a production date of the removable battery 14, initial performance (a capacity and a resistance value) of the removable battery 14, histogram data of the temperature of the removable battery 14, and histogram data of an SOC of the removable battery 14. The information acquirer 1673 acquires time-series data of a battery voltage and an electric current at the time of charging.

(Step S102) The controller 167 adds identification information of the charging station to the acquired battery information and information about battery performance and transmits the information to the management server 18. The battery information includes, for example, the number of days after the removable battery 14 was produced, initial performance (a capacity and a resistance value), histogram data of the temperature of a battery, and histogram data of an SOC of the battery. The information about the battery performance includes time-series data (a voltage, an electric current, and the temperature) at the time of charging at the charging station 16.

(Step S103) The information acquirer 1831 of the management server 18 acquires the battery information and the information about the battery performance transmitted by the charging station 16 via the communicator 181. Subsequently, the estimator 1833 estimates the battery performance (the capacity and the resistance value) according to a well-known method using the time-series data included in the acquired information about the battery performance. After the processing in the estimator 1833, the process proceeds to the processing of step S5.

(Step S5) The management server 18 performs the processing of step S5.

(Step L2) The replacement work of the removable battery 14 is completed.

A procedure of processing machine learning of the battery deterioration prediction model is the same as that of Fig. 6. The management server 18 performs machine learning using the estimated battery performance (the capacity and the resistance value).

As described above, even if the teacher data at the time of machine learning is about battery performance actually measured by the charging station 16 as in the embodiment, current battery performance values (a capacity and resistance) estimated by the management server 18 may be used as in the first modified example.

When the battery performance is estimated by the management server 18, the information about the battery performance acquired by the charging station 16 may be time-series data of each of a voltage, an electric current, and the temperature at the time of charging.

As described above, in the first modified example, the battery performance is estimated. Thereby, according to the first modified example, it is not necessary to actually measure the battery performance of the battery. Also, according to the first modified example, the prediction accuracy can be improved each time the number of samples of data received from the charging station 16 increases.

As described in the first embodiment, the charging station 16 may transmit at least one of the measured values obtained by measuring the battery performance of the removable battery 14 and the time-series data at the time of charging to the management server 18. In this case, the management server 18 may perform machine learning using the received information about the battery performance (the measured values and the time-series data).

### [Second modified example]

Also, although an example in which the charging station 16 transmits battery performance and battery information to the management server 18 has been described in the above-described example, the present invention is not limited thereto. For example, when the motorcycle 12 includes a telematics communication unit (TCU) having a communication function, the TCU may transmit the battery performance and the battery information to the management server 18 at a predetermined time or at a predetermined time interval.

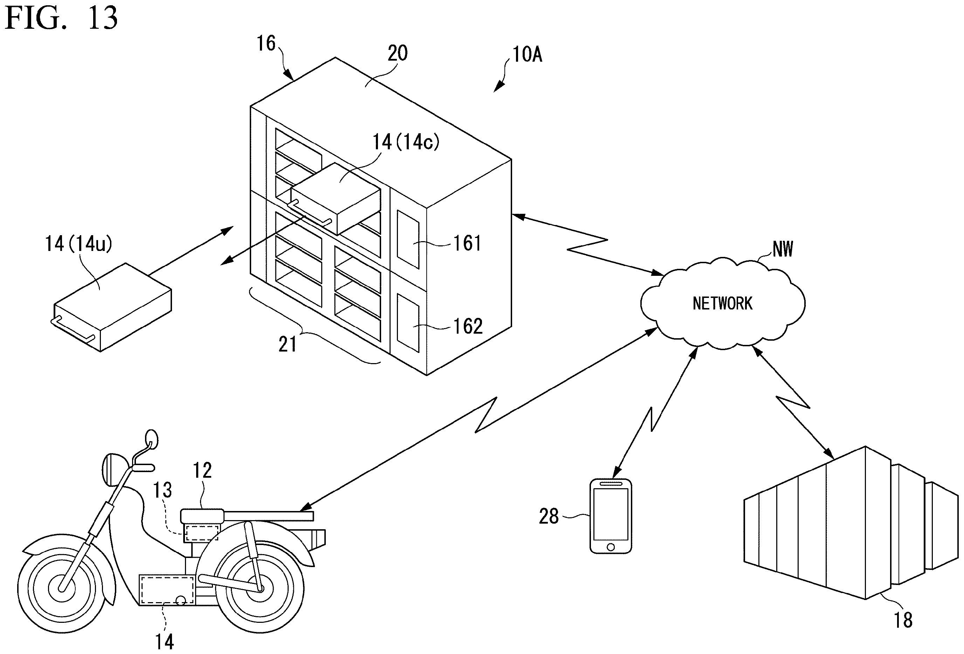

Fig. 13 is a diagram showing the overall configuration of a battery deterioration estimation system 10A according to a second modified example of the present embodiment. As shown in Fig. 13, the battery deterioration estimation system 10A includes a saddle-riding type motorcycle 12 (a saddle-riding type vehicle), a TCU 13, a removable battery 14 (a battery), a charging station 16, a management server 18, and a portable terminal 28. Components having functions similar to those of the battery deterioration estimation system 10 are denoted by the same reference signs and a description thereof will be omitted.

The TCU 13 is a communication unit mounted within the motorcycle 12. The TCU 13 acquires battery information (a production date, initial performance (a capacity and a resistance value), the temperature histogram, and an SOC histogram), which is stored in the storage device 144 (Fig. 2) of the removable battery 14, and transmits the acquired battery information to the management server 18 via a network NW. A transmission timing is, for example, a predetermined time or a predetermined time interval (for example, every minute).

In this case, as in the battery deterioration estimation system 10, the charging station 16 also estimates the battery performance (the capacity and the resistance value) when the removable battery 14 has been returned and reads the battery information from the removable battery 14. The charging station 16 transmits the battery information regarding the estimated battery performance to the management server 18.

The controller 183 (Fig. 4) of the management server 18 receives battery information from the TCU 13 via the communicator 181 (Fig. 4). The controller 183 of the management server 18 receives the battery performance and the battery information from the charging station 16 via the communicator 181. The model generator 1832 (Fig. 4) of the management server 18 generates a battery deterioration prediction model through machine learning using the battery information (a time-series history) received from the TCU 13 and the charging station 16 and the battery performance received from the charging station 16.

In the above-described second modified example, it is also possible to obtain effects similar to those of the battery deterioration estimation system 10. In the modified example, because the battery information (the time-series history) can also be obtained from the TCU 13, so that more accurate learning can be performed using the battery information.

### [Other modified examples]

Although a case in which the information acquirer 1831 of the management server 18 indirectly acquires the battery information and the battery performance information of the removable battery 14 from the charging station 16 via the communicator 181 has been described in the description of the above-described embodiment, the present invention is not limited thereto. For example, the information acquirer 1831 of the management server 18 may acquire the battery information and the battery performance information of the removable battery 14 directly from the removable battery 14 via the communicator 181. In this case, the removable battery 14 may include a communicator 146 that communicates with the management server 18 or the like in addition to the power storage battery 141, the measurement sensor 142, the BMU 143, the storage device 144, and the connector 145. The communicator 146 of the removable battery 14 transmits the battery information and the battery performance information to the management server 18. Thereby, the management server 18 can directly communicate with the removable battery 14 without involving the charging station 16, so that a change in the deterioration of the removable battery 14 can be predicted.

The above-described embodiment can be expressed as follows.
(1) According to an embodiment of the present invention, the battery deterioration estimation system 10 includes the removable battery 14 removably mounted on the motorcycle 12 movable using electric power and configured to store battery information including a parameter for enabling deterioration of the battery to be determined; the charging station 16 configured to charge the removable battery 14, acquire the battery information from the removable battery 14, acquire battery performance information about battery performance of the removable battery 14, and transmit the battery performance information and the battery information to a server device; and the management server 18 configured to designate the battery information received from the charging station 16 as learning data, designate the battery performance as teacher data, generate a battery deterioration prediction model of the removable battery 14 according machine learning, designate the battery information as input data, and estimate battery performance at the time of estimation using the battery deterioration prediction model.
(2) In the battery deterioration estimation system 10, the battery information may include the number of days elapsed after the removable battery 14 was produced, the initial capacity of the removable battery 14, and the initial resistance value of the removable battery 14, a histogram of the temperature of the removable battery 14, and a histogram of the remaining capacity of the removable battery 14 and the battery performance may include a capacity of the removable battery 14 at the time of measurement and a resistance value of the removable battery 14 at the time of measurement.
(3) In the battery deterioration estimation system 10, the battery information may include the number of days elapsed after the removable battery 14 was produced, the initial capacity of the removable battery 14, and the initial resistance value of the removable battery 14, the standard deviation and the average value in the temperature of the removable battery 14, and the standard deviation and the average value in the remaining capacity of the removable battery 14 and the battery performance may include the capacity of the removable battery 14 at the time of measurement and the resistance value of the removable battery 14 at the time of measurement.
(4) In the battery deterioration estimation system 10, the charging station 16 may acquire battery performance information and battery information when the removable battery 14 has been returned and transmit the battery performance information and battery information to the management server 18.
(5) In the battery deterioration estimation system 10, the charging station 16 may acquire the battery performance information and the battery information for a period in which the removable battery 14 is rented out after the removable battery 14 is returned and transmit the battery performance information and the battery information to the management server 18.
(6) In the battery deterioration estimation system 10, the battery performance information may be at least one of measured values of a capacity and a resistance value obtained by measuring the battery performance of the removable battery 14 and time-series data of the voltage, the electric current, and the temperature when the removable battery 14 is charged.
(7) According to another aspect of the present invention, the management server 18 includes the information acquirer 1673 configured to acquire battery information from the removable battery 14 which is removably mounted on the motorcycle 12 movable using electric power and which stores the battery information including a parameter for enabling deterioration of the battery to be determined and acquire battery performance information about battery performance of the removable battery 14 measured by the charging station 16 configured to charge the removable battery 14; the model generator 1832 configured to designate the battery information as learning data, designate the battery performance information as teacher data, and generate a battery deterioration prediction model of the removable battery 14 through machine learning; and the estimator 1833 configured to estimate battery performance at the time of measurement using the deterioration prediction model.

Also, all or a part of processing to be performed by the management server 18 may be performed by recording a program for implementing all or some of the functions of the management server 18 according to the present invention on a computer-readable recording medium and causing a computer system to read and execute the program recorded on the recording medium. Also, the "computer system" used here is assumed to include an operating system (OS) and hardware such as peripheral devices. In addition, the computer system is assumed to include a homepage providing environment (or displaying environment) when a World Wide Web (WWW) system is used. In addition, the "computer-readable recording medium" refers to a storage device, including a flexible disk, a magneto-optical disc, a read only memory (ROM), a portable medium such as a compact disc (CD)-ROM, and a hard disk embedded in the computer system. Further, the "computer-readable recording medium" is assumed to include a computer-readable recording medium for retaining the program for a predetermined time period as in a volatile memory (a random access memory (RAM)) inside the computer system including a server and a client when the program is transmitted via a network such as the Internet or a communication circuit such as a telephone circuit.

Also, the above-described program may be transmitted from a computer system storing the program in a storage device or the like via a transmission medium or transmitted to another computer system by transmission waves in a transmission medium. Here, the "transmission medium" for transmitting the program refers to a medium having a function of transmitting information, such as a network (a communication network) like the Internet or a communication circuit (a communication line) like a telephone circuit. Also, the above-described program may be a program for implementing some of the above-described functions. Further, the above-described program may be a program capable of implementing the above-described function in combination with a program already recorded on the computer system, i.e., a so-called differential file (differential program).

Although modes for carrying out the present invention have been described above using the embodiments, the present invention is not limited to the embodiments and various modifications and replacements can be applied without departing from the spirit and scope of the present invention.

### DESCRIPTION OF REFERENCE NUMERALS

- 10, 10A: Battery deterioration estimation system
- 12: Motorcycle (electric power device)
- 13: TCU
- 14: Removable battery
- 16: Charging station (charging device)
- 18: Management server (estimation device)
- 28: Portable terminal
- 20: Housing
- 21: Slot unit
- 141: Power storage battery
- 142: Measurement sensor
- 143: BMU
- 144: Storage device
- 145: Connector
- 161: Display
- 162: Authenticator
- 163: Charger
- 164: Connector
- 165: Communicator
- 166: Storage device
- 167: Controller
- 1671: Charging controller
- 1672: Measurement sensor
- 1673: Information acquirer
- 1674: Processor
- 181: Communicator
- 182: Storage device
- 183: Controller
- 184: Outputter
- 1831: Information acquirer
- 1832: Model generator (learner)
- 1833: Estimator

## Claims

1. An estimation system comprising:
a battery removably mounted on an electric power device using electric power;
a charging device; and
an estimation device,
wherein the charging device comprises
a charger configured to charge the battery;
an acquirer configured to acquire first information about deterioration of the battery from the battery; and
a transmitter configured to transmit the first information acquired by the acquirer, and
wherein the estimation device comprises
a receiver configured to receive the first information transmitted by the transmitter; and
an estimator configured to estimate performance of the battery when the first information received by the receiver is input to a model, the model having been learned to output second information about the performance of the battery at a certain point in time when the first information of the battery is input at the point in time.

2. The estimation system according to claim 1, wherein the estimation device further comprises a learner configured to learn the model based on teacher data in which the second information of the battery at the point in time is associated with the first information of the battery at the point in time.

3. The estimation system according to claim 1 or 2, wherein the first information comprises at least one of the number of days elapsed after the battery was produced, an initial capacity of the battery, an initial resistance value of the battery, a histogram of a temperature of the battery, and a histogram of the remaining capacity of the battery.

4. The estimation system according to any one of claims 1 to 3, wherein the second information comprises one or both of a capacity of the battery at the time of measurement and a resistance value of the battery at the time of measurement.

5. The estimation system according to any one of claims 1 to 4, wherein the first information comprises at least one of the number of days elapsed after the battery was produced, an initial capacity of the battery, an initial resistance value of the battery, a standard deviation and an average value in a temperature of the battery, and a standard deviation and an average value in the remaining capacity of the battery.

6. The estimation system according to any one of claims 1 to 5,
wherein the acquirer of the charging device acquires the first information and the second information when the battery has been mounted on the charging device, and
wherein the transmitter of the charging device transmits the first information and the second information acquired by the acquirer to the estimation device.

7. The estimation system according to any one of claims 1 to 6,
wherein the acquirer of the charging device acquires the first information and the second information for a period from the time when the battery is mounted on the charging device to the time when the battery is removed from the charging device, and
wherein the transmitter of the charging device transmits the first information and the second information acquired by the acquirer to the estimation device.

8. The estimation system according to any one of claims 1 to 7, wherein the second information comprises at least one of measured values of a capacity and a resistance value obtained by measuring the performance of the battery and time-series data of each of a voltage, an electric current, and a temperature when the battery is charged.

9. An estimation system comprising:
a battery removably mounted on an electric power device using electric power; and
an estimation device,
wherein the battery comprises
an acquirer configured to acquire first information about deterioration of the battery; and
a transmitter configured to transmit the first information acquired by the acquirer, and
wherein the estimation device comprises
a receiver configured to receive the first information transmitted by the transmitter; and
an estimator configured to estimate performance of the battery when the first information received by the receiver is input to a model, the model having been learned to output second information about the performance of the battery at a certain point in time when the first information of the battery is input at the point in time.

10. An estimation device comprising:
a receiver configured to receive first information about deterioration of a battery transmitted by a charging device configured to charge the battery removably mounted on an electric power device using electric power; and
an estimator configured to estimate performance of the battery when the first information received by the receiver is input to a model, the model having been learned to output second information about the performance of the battery at a certain point in time when the first information of the battery is input at the point in time.

11. An estimation method comprising a step of:
estimating, by a computer comprising a receiver configured to receive first information about deterioration of a battery transmitted by a charging device configured to charge the battery removably mounted on an electric power device using electric power, performance of the battery when the first information received by the receiver is input to a model, the model having been learned to output second information about the performance of the battery at a certain point in time when the first information of the battery is input at the point in time.

12. A program for causing a computer, which comprises a receiver configured to receive first information about deterioration of a battery transmitted by a charging device configured to charge the battery removably mounted on an electric power device using electric power, to execute a step of:
estimating performance of the battery when the first information received by the receiver is input to a model, the model having been learned to output second information about the performance of the battery at a certain point in time when the first information of the battery is input at the point in time.

13. A computer-readable storage medium storing the program according to claim 12.
